(19) **Europäisches Patentamt European Patent Office Office européen des brevets**

(11) **EP 4 566 134 B1**

(12) **FASCICULE DE BREVET EUROPEEN**

(45) Date de publication et mention de la délivrance du brevet:
**20.05.2026 Bulletin 2026/21**

(21) Numéro de dépôt: **23745589.4**

(22) Date de dépôt: **28.07.2023**

(51) Classification Internationale des Brevets (IPC):
*H01S 5/042* (2006.01)    *H01S 5/062* (2006.01)
*H01S 5/183* (2006.01)

(52) Classification Coopérative des Brevets (CPC):
**H01S 5/06236; H01S 5/04254; H01S 5/04256; H01S 5/0427; H01S 5/18302; H01S 5/18355**

(86) Numéro de dépôt international:
**PCT/EP2023/071083**

(87) Numéro de publication internationale:
**WO 2024/028239 (08.02.2024 Gazette 2024/06)**

(54) **SYSTÈME D'ÉMISSION LUMINEUSE À INJECTEUR DE SPIN**

**SPIN-INJEKTOR-LICHTEMISSIONSSYSTEM**

**SPIN INJECTOR LIGHT EMISSION SYSTEM**

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **04.08.2022 FR 2208077**

(43) Date de publication de la demande:
**11.06.2025 Bulletin 2025/24**

(73) Titulaires:
  • **THALES**
    **92190 Meudon (FR)**
  • **Centre National de la Recherche Scientifique**
    **75016 Paris (FR)**
  • **Université de Lorraine**
    **54052 Nancy Cedex (FR)**

(72) Inventeurs:
  • **LU, Yuan**
    **54011 Nancy (FR)**
  • **GEORGE, Jean-Marie**
    **91767 Palaiseau (FR)**

  • **JAFFRES, Henri**
    **91767 Palaiseau (FR)**
  • **CRETE, Denis**
    **91767 Palaiseau (FR)**

(74) Mandataire: **Atout PI Laplace**
    **Immeuble Up On**
    **25 Boulevard Romain Rolland**
    **CS 40072**
    **75685 Paris Cedex 14 (FR)**

(56) Documents cités:
    **EP-A1- 1 478 066      JP-A- 2011 082 388**

  • **YOKOTA NOBUHIDE ET AL: "Spin polarization modulation for high-speed vertical-cavity surface-emitting lasers", APPLIED PHYSICS LETTERS, AMERICAN INSTITUTE OF PHYSICS, 2 HUNTINGTON QUADRANGLE, MELVILLE, NY 11747, vol. 113, no. 17, 22 October 2018 (2018-10-22), XP012232610, ISSN: 0003-6951, [retrieved on 20181022], DOI: 10.1063/1.5040914**

## Description

### DOMAINE DE L'INVENTION

La présente invention concerne un système d'émission lumineuse de type Diode Electroluminescente de spin (spin-LED en anglais) ou laser de spin (spin-laser), et plus particulièrement un système d'émission lumineuse permettant une modulation de la polarisation de la lumière émise par le système.

### ETAT DE LA TECHNIQUE

Au cours des dernières années, en raison de l'essor de nouvelles applications impliquant l'intelligence artificielle, le Big Data, l'IoT et la 5G, les technologies de communication optique et d'interconnexion optique sont de plus en plus utilisées dans diverses applications allant du flux de données Internet et des superordinateurs aux centres de données à grande échelle. Ces technologies optiques permettent de répondre aux besoins d'augmentation de la capacité et de la vitesse de communication ainsi que de réduction de la consommation d'énergie.

Dans les systèmes de communication optique actuels, la transmission du signal utilise la fréquence ou la longueur d'onde (multiplexage par répartition en longueur d'onde ou DWDM pour Dense Wavelength Division Multiplexing en anglais), la phase (modulation QPSK pour Quadrature Phase Shift Keying en anglais) ou l'amplitude (modulation PAM4 de 4e ordre ou Pulse Amplitude Modulation en anglais) pour le codage. Une augmentation supplémentaire du taux de transmission, de la capacité et de la bande passante devient très difficile.

La polarisation est le dernier paramètre physique réglable de la lumière sur lequel on peut agir. Actuellement seule la polarisation linéaire est utilisée comme paramètre statique pour améliorer les systèmes de communication parallèles (DP-QPSK, DP-QAM, DP pour Dual Polarization en anglais). La modulation directe à grande vitesse de la polarisation de la lumière et l'exploitation supplémentaire du degré de liberté de la polarisation circulaire peuvent servir de base pour une nouvelle technologie de communication permettant de repousser les limitations en débit qui constituent aujourd'hui le principal goulot d'étranglement des télécommunications optiques.

La technologie spintronique permet d'effectuer une modulation de la polarisation circulaire émise. On dénomme polarisation de spin d'un électron l'état de spin (Up ou Down) de l'électron. Un électron polarisé en spin est un électron qui présente un état de spin (up ou down) maîtrisé et connu, en anglais « spin polarized electron ». Dans la suite nous dénommerons cet électron « électron de spin ».

Il a été démontré que l'injection dans un dispositif d'émission (LED ou laser) d'électrons de spin (dénommée injection de spin ou « spin injection » en anglais) pouvait générer une polarisation préférentielle de la lumière émise dans un des deux états de polarisation circulaire gauche (CG) ou circulaire droit (CD) (voir par exemple la publication « Injection and detection of a spin-polarized current in a light-emitting diode », Nature, Vol 402 1999). On définit le taux de polarisation circulaire (ou contraste de polarisation) Pc de la lumière selon:

$$Pc = (\sigma^+ - \sigma^-)/(\sigma^+ + \sigma^-)$$

avec $\sigma^+$, $\sigma^-$ l'intensité lumineuse (densité de photons) respectivement dans l'état de polarisation CD, CG.

L'injection de spin consiste à injecter depuis une couche ferromagnétique, en général de type métallique, des électrons de spin (c'est-à-dire présentant une polarisation de spin, soit un état de spin, up ou down, majoritaire) dans une couche conductrice, la polarisation de spin de ces électrons injectés étant au moins partiellement transmise aux électrons effectuant le transport électrique (transport de charge) dans la LED et/ou le laser, alors dénommés spin LED ou spin laser.

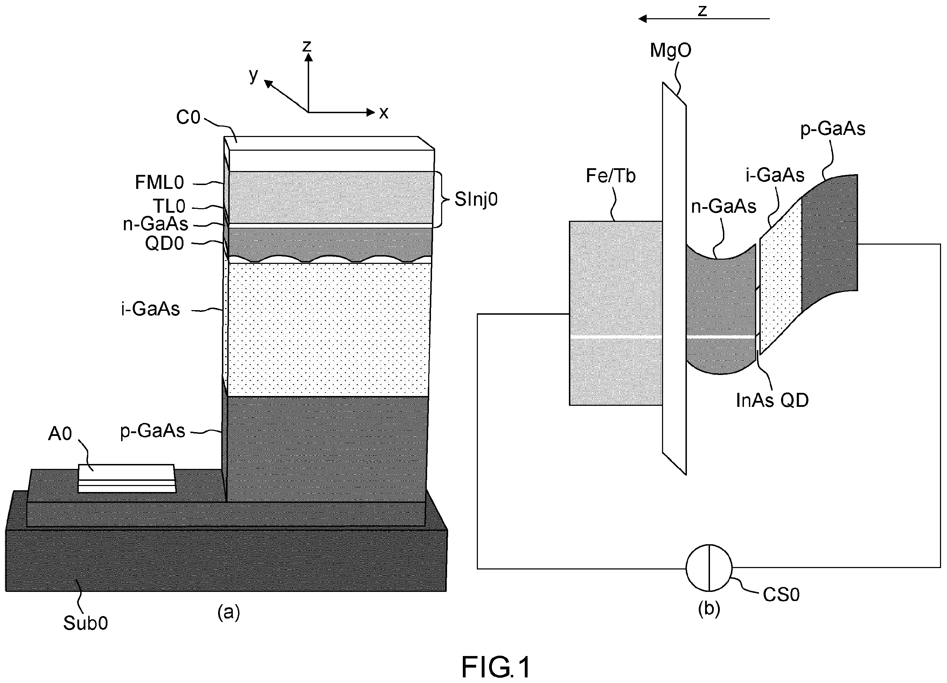

Pratiquement on dépose une couche ferromagnétique en tant qu'injecteur de spin sur la partie supérieure d'une diode électroluminescente ou d'un laser à émission verticale. Un exemple, décrit dans la publication de revue « Spin Controlled Vertical Cavity Surface Emiitting Lasers » de Nils C. Gerhardt et al (Advances in Optical technology, vol 2012, Article ID268949) est illustré figure 1. En a) est schématisé l'empilement de la spin LED et en b) le diagramme de bande associé (l'axe perpendiculaire à z correspond à un axe d'énergie). La LED est de technologie classique de type p-i-n GaAs (ou AlGaAs) et présente une couche active QD0 en boîtes quantiques (« quantum dot » QD en anglais) à base d'InAs ou InGaAs et des couches de transport n-GaAs, i-GaAs et p-GaAs déposées sur un substrat semiconducteur Sub0. L'injecteur de spin SInj0 déposé sur la couche n-GaAs comprend une couche ferromagnétique FML0 consistant en une bicouche ou multicouche ferromagnétique, par exemple constituée de Fe/Tb, Co/Pt, Fe/Pt/Co/Ni, MnGa présentant une aimantation selon z perpendiculaire au plan des couches. Il est également préférable d'utiliser une couche supplémentaire isolante TL0, par exemple en MgO (oxyde de magnésium), AlOx (alumine) ou une barrière Schottky (assez fine pour transmettre les électrons par principe d'effet tunnel), permettant d'adapter la résistivité entre l'injecteur et la couche supérieure de l'empilement de la LED n-GaAs afin d'obtenir une meilleure efficacité d'injection de spin. Deux électrodes, une cathode C0 (contact n, typiquement en or) et une anode A0 (contact p, typiquement en or) permettent l'injection des porteurs de charge (imposée par une source de courant CS0). La cathode C0 est déposée sur l'injecteur et l'anode est en contact avec la couche p-GaAs. Les électrons de spin sont injectés de la couche ferromagnétique, par exemple la couche de Fe inférieure de la multicouche Fe/Tb, ou équivalente comme décrit plus haut, dans la couche n-GaAs via la couche en MgO (également dite barrière tunnel), et se recombinent avec les trous non polarisés dans la couche active QD0.

L'injection des électrons polarisés en spin dans la LED/le laser conduit à l'émission de lumière polarisée circulairement via des règles de sélection optique décrivant la conservation du moment cinétique lors des recombinaisons (transitions quantiques) des électrons qui changent de bande. Selon ces règles de sélection optique, la polarisation circulaire de la lumière émise est proportionnelle à la polarisation de spin injectée électriquement. Une commutation entre les deux états de polarisation CG et CD de la lumière est alors possible en réalisant une inversion de la direction de l'aimantation de la couche ferromagnétique. Sur cette base, à condition que la condition d'inversion de population soit atteinte, le fonctionnement du laser de spin est obtenu en ajoutant une cavité optique au milieu à gain semi-conducteur de la LED de spin. Le spin-laser est généralement un laser à émission de surface à cavité verticale (externe) ou VCSEL.

Les spin-lasers possèdent deux avantages qui leur sont propres. Premièrement, même avec une faible injection d'électrons polarisés en spin (2-3%), le laser de spin peut émettre de la lumière avec une polarisation circulaire approchant 100%, agissant ainsi comme un amplificateur de spin. La raison en est que l'anisotropie de gain circulaire induite par l'injection de spin entraîne un déséquilibre d'intensité important entre les deux modes propres circulaires, en raison de la forte compétition de modes dans le milieu actif. Ce déséquilibre peut générer une commutation complète entre les deux modes propres si la compétition de mode est suffisamment élevée. Le deuxième avantage est la réduction du courant de seuil de près de moitié par rapport à un laser "classique".

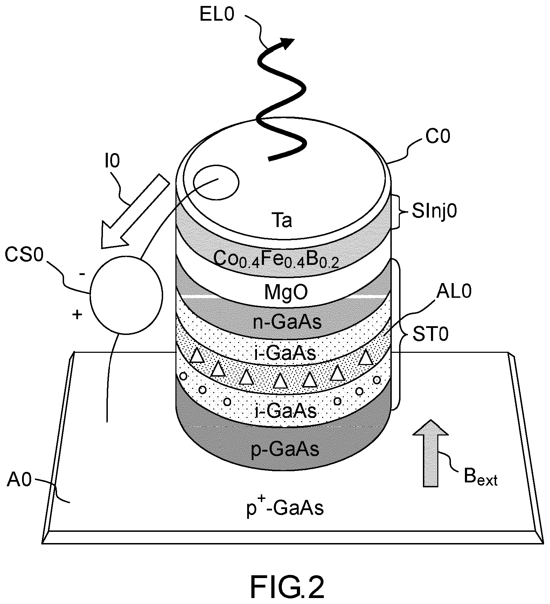

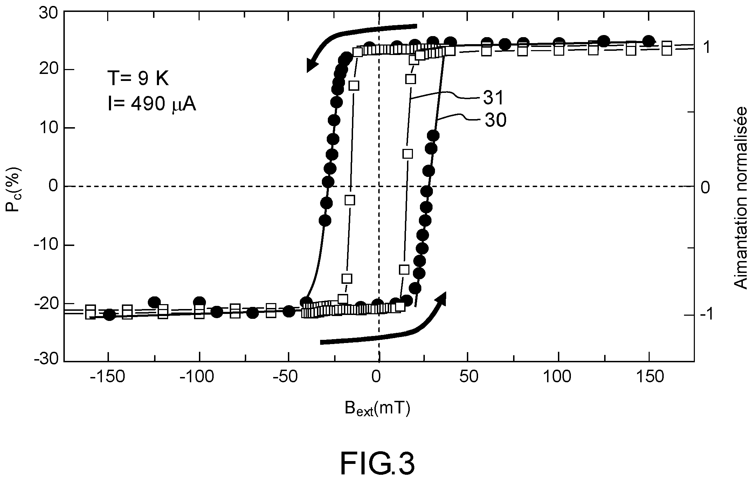

Récemment la publication « Electrical Initialization of Electron and Nuclear Spins in a Single Quantum dot at zero magnetic field » (Cadiz et al , Nano Letters, 18, 2381-2386, 2018) a décrit un injecteur de spin Sinj0 à base de fines couches ferromagnétiques de CoFeB (avec une électrode C0 en tantale Ta) déposé sur une LED, la LED présentant un empilement ST0 comprenant une couche active AL0 comprenant des boîtes quantiques InGaAs/GaAs (dénommés QD pour Quantum Dot en anglais) et des couches de transport, tel qu'illustré figure 2. Un courant I0 appliqué au dispositif permet une émission lumineuse EL0. Le courant de polarisation du dispositif (pour l'électroluminescence) et le courant des électrons de spin coïncident. Il a été obtenu un taux de polarisation Pc jusqu'à 35 % à champ magnétique appliqué nul, à partir d'un seul QD. La figure 2 illustre l'empilement LED/injecteur de spin et la figure 3 illustre la commutation d'une polarisation circulaire à l'autre de la lumière émise par le dispositif de la figure 2 en fonction d'un champ $B_{ext}$ appliqué (à une température T=9K et un courant I0= 490 $\mu$A). L'application du champ extérieur $B_{ext}$ permet de modifier la direction de l'aimantation de la couche ferromagnétique de l'injecteur (changer son sens). Une fois la commutation de l'aimantation de la couche ferromagnétique effectuée, on peut s'abstenir d'appliquer le champ extérieur, qui ne sert que pour la commutation. La courbe 30 illustre la commutation de polarisation avec un changement de Pc de -20% à +20% en fonction de la valeur et de l'orientation du champ $B_{ext}$. La courbe 31 illustre la boucle d'hystérésis de l'aimantation (normalisée à l'aimantation de saturation) de la couche ferromagnétique CoFeB. Le comportement du taux de polarisation Pc en fonction du signe du champ $B_{ext}$ est en adéquation avec la boucle d'hystérésis de l'aimantation normalisée de la couche CoFeB. La polarisation de la lumière émise est bien caractéristique de la polarisation des électrons de spin, polarisés par l'aimantation de la couche ferromagnétique. D'un point de vue fondamental cette étude montre une signature de la polarisation dynamique des spins nucléaires dans le QD, induite par l'interaction hyperfine avec le spin électronique injecté électriquement.

La publication Liang et al (Physical Review B, 90, 085310, 2014) décrit un injecteur de spin aimanté perpendiculairement au plan des couches constitué d'un empilement de couches ultrafines en MgO (2,5 nm)/Co-FeB (1,2 nm)/Ta déposées sur une LED GaAs QW (QW pour Quantum Well en anglais). La valeur de Pc qui a été mesurée est de 13% à 25K et 8% à 300K à champ magnétique nul.

L'application de forts champs magnétiques par une bobine/électroaimant conventionnel n'est pas adaptée aux applications pratiques. Sur des critères de rapidité et d'adressage sélectif d'un élément particulier (de taille micrométrique) dans un ensemble disposé en réseau ou en matrice, le défi consiste à commuter ou moduler électriquement l'aimantation de l'injecteur de spin pour contrôler la polarisation circulaire de sortie, en s'affranchissant de toute commutation par le biais d'un champ magnétique externe.

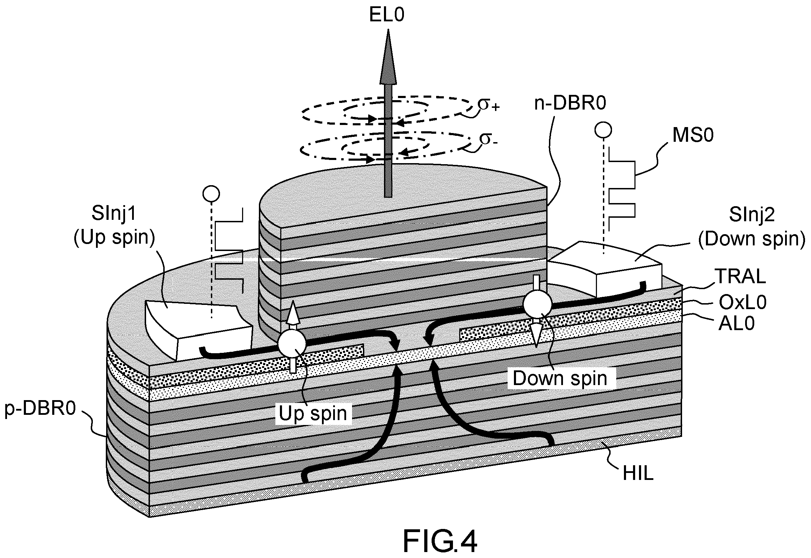

Une solution de commutation électrique de spin est basée sur la fabrication, sur la partie supérieure du spin-VCSEL, d'une paire d'électrodes d'injection de spin SInj1 et SInj2 dont l'aimantation est anti-parallèle (Up Spin et Down Spin), comme illustré sur la Figure 4, issue de la publication «Spin polarization modulation for high-speed vertical-cavity surface-emitting lasers» Yokota et al (Applied Physics Letters 113, 171102, 2018). En modulant et contrôlant la contribution du courant injecté à partir de chaque injecteur, via un signal de modulation MS0, on obtient la commutation de l'hélicité recherchée c'est-à-dire du sens de la polarisation circulaire (gauche □$^-$ ou droite □$^+$) de la lumière émise EL0. Le spin-VCSEL de la figure 4 comprend une couche de transport TRAL, une couche active AL0, une couche d'oxyde OxL0 délimitant la circulation des électrons, deux miroirs de Bragg n-DBR0 et p-DBR0 formant la cavité laser et une électrode d'injection de trous HIL. Deux injecteurs de spin présentant une aimantation opposée sont disposés sur la couche de transport TRAL. Chaque injecteur de spin comprend une bicouche ferromagnétique/métal de type Fe/Pt ou équivalent comme cité plus haut, pour donner in fine une structure de type semiconducteur/MgO/Fe/Pt.

Bien que cette méthode soit simple et pratique, chaque changement de polarisation nécessite une nouvelle étape d'injection de courant dans chaque électrode de spin. Un fonctionnement en mode d'émission continue est donc problématique. Par rapport à la modulation classique de l'intensité lumineuse pour les télécommunications, cette méthode n'est pas compétitive. En effet, pour un débit de données très élevé ou une transmission à très longue distance, une source laser doit fonctionner en mode continu. Cela évite l'effet de «chirp» laser, qui élargit la largeur de raie des lasers modulés directement et augmente la dispersion chromatique dans la fibre. Le mode de fonctionnement idéal pour les télécommunications optique est de maintenir une intensité lumineuse constante tout en modulant la polarisation circulaire. Un autre désavantage de cette architecture est que le placement des injecteurs de spin autour de la base mésa du laser nécessite, en plus du transport longitudinal, un transport de spin latéral sur plusieurs micromètres afin que les électrons de spin, qui sont aussi les électrons dit d'illumination générant l'émission lumineuse, atteignent la région active du laser. Cela diminue largement l'efficacité d'injection de spin en raison de la longueur de diffusion de spin limitée dans le GaAs ($\sim\mu m$), empêchant ainsi d'obtenir un polarisation circulaire élevée.

Un but de la présente invention est de remédier aux inconvénients précités en proposant un système d'émission lumineuse de type spin-LED ou spin-laser, réalisant une commutation rapide de l'hélicité de la polarisation circulaire de la lumière émise, commandée électriquement à l'aide d'une structure d'injecteur de spin originale permettant l'obtention d'une polarisation Pc élevée et un fonctionnement en mode continu du dispositif.

## DESCRIPTION DE L'INVENTION

La présente invention a pour objet Système d'émission lumineuse de type spin-LED ou spin-laser comprenant :

- un empilement déposé sur un substrat selon un axe Z perpendiculaire au plan XY du substrat et comprenant une couche active et des couches de transport,
- une électrode dénommée anode et une électrode dénommée cathode configurées pour générer des porteurs de charge qui traversent l'empilement jusqu'à la couche active,
- un dispositif dit injecteur de spin déposé sur ledit empilement et comprenant :

  *un ensemble d'au moins une première couche en matériau ferromagnétique et d'au moins une deuxième couche en matériau métallique, ledit ensemble présentant une structure de barre dénommée barre de Hall selon un axe X et présentant une première extrémité et une deuxième extrémité,

*une première électrode et une deuxième électrode, dites de spin, en contact électrique avec respectivement la première et la deuxième extrémité de la barre de Hall, et configurées pour générer, dans la barre de Hall, un courant I impulsionnel selon l'axe X dans un premier sens ou un deuxième sens opposé au premier sens,

- le système d'émission étant configuré de sorte que la cathode est en contact électrique avec la barre de Hall de l'injecteur de spin,
- ledit injecteur de spin étant configuré pour présenter une aimantation selon Z et pour qu'une inversion du sens du courant I réalise une inversion du sens de l'aimantation, une commutation de l'aimantation de l'injecteur de spin induisant une modification de l'état de polarisation circulaire de la lumière émise par le système d'émission.

Selon une variante le système d'émission selon l'invention est de type spin-laser, dans lequel l'empilement comprend en outre un premier miroir disposé sur le substrat et un deuxième miroir agencé de sorte que l'injecteur soit disposé à l'intérieur d'une cavité optique formée par le premier et le deuxième miroir.

Selon un mode de réalisation du système d'émission de type spin-laser le deuxième miroir est disposé sur l'injecteur de spin et est un miroir de Bragg.

Selon un mode de réalisation une longueur de la barre de Hall est supérieure ou égale à 2.5 fois une largeur de ladite barre de Hall.

Selon un mode de réalisation le système d'émission lumineuse selon l'invention comprend en outre une couche mince isolante disposée entre l'injecteur de spin et l'empilement.

Selon un mode de réalisation le système d'émission lumineuse selon l'invention comprend en outre une couche de masquage opaque à la lumière émise, disposée sur l'injecteur de spin, et présentant une ouverture circulaire de surface inscrite dans la barre de Hall et délimitant la zone d'émission lumineuse.

Selon un mode de réalisation la première couche, la deuxième couche et, le cas échéant, la couche mince isolante, présentent chacune une épaisseur inférieure à 5 nm.

Selon un mode de réalisation l'empilement est configuré de sorte qu'une distance entre l'injecteur de spin et la couche active est inférieure à 100 nm.

Selon un mode de réalisation la cathode et l'une des électrodes de spin forment une seule et même électrode.

Selon un mode de réalisation la cathode est en contact avec la barre de Hall via une paroi latérale de la barre de Hall.

Selon un mode de réalisation le système d'émission lumineuse selon l'invention comprend en outre une électrode additionnelle en contact électrique avec la barre de Hall via une paroi latérale du côté opposé à la cathode.

Selon un mode de réalisation le système d'émission lumineuse selon l'invention comprend en outre un dispositif de génération d'un champ magnétique dit externe selon l'axe X.

Selon un mode de réalisation l'empilement est entouré par un matériau isolant et forme avec l'empilement une surface supérieure plane sur laquelle sont disposés l'injecteur de spin et la cathode.

La description suivante présente plusieurs exemples de réalisation du dispositif de l'invention: ces exemples sont non limitatifs de la portée de l'invention. Ces exemples de réalisation présentent à la fois les caractéristiques essentielles de l'invention ainsi que des caractéristiques additionnelles liées aux modes de réalisation considérés.

L'invention sera mieux comprise et d'autres caractéristiques, buts et avantages de celle-ci apparaîtront au cours de la description détaillée qui va suivre et en regard des dessins annexés donnés à titre d'exemples non limitatifs et sur lesquels:

La figure 1 déjà citée illustre l'architecture d'une spin LED selon l'état de l'art.

La figure 2 déjà citée illustre l'architecture d'une spin LED présentant une couche active à base de «quantum dot» selon l'état de la technique.

La figure 3 déjà citée illustre, pour la spin LED de la figure 2, la commutation d'une polarisation circulaire à l'autre en fonction d'un champ magnétique extérieur appliqué.

La figure 4 déjà citée illustre un spin laser présentant deux injecteurs de spin permettant une commutation électrique de la polarisation circulaire selon l'état de la technique.

La figure 5 illustre un système d'émission selon l'invention de type spin-LED selon une première variante (vue de profil)

La figure 6 illustre le système d'émission selon l'invention de type spin-laser selon une première variante (vue de profil)

La figure 7 illustre le principe de fonctionnement de l'injecteur de spin selon l'invention.

La figure 8 illustre un premier mode de réalisation du système d'émission selon l'invention dans lequel la cathode et la deuxième électrode de spin forment une seule et même électrode (vue de dessus).

La figure 9 illustre un deuxième mode de réalisation du système d'émission selon l'invention dans lequel la cathode est en contact avec la barre de Hall HB via une paroi latérale (vue de dessus).

La figure 10 illustre le principe de l'effet Hall de spin.

La figure 11 illustre le fonctionnement de l'injecteur de spin selon l'invention pour le premier mode de réalisation.

La figure 12A illustre le fonctionnement de l'injecteur de spin selon l'invention pour le deuxième mode de réalisation.

La figure 12B illustre la dépendance temporelle des 3 composantes de l'aimantation, respectivement Mx, My et Mz, pour un injecteur de spin selon l'invention pour le deuxième mode de réalisation. La commutation magnétique obtenue par injection d'un courant pulsé, avec une aimantation initiale de la couche ferromagnétique orientée selon Z et le pulse de courant est appliqué sans champ magnétique externe (Hext=0).

La figure 12C illustre la dépendance temporelle des 3 composantes de l'aimantation, respectivement Mx, My et Mz, pour un injecteur de spin selon l'invention pour le deuxième mode de réalisation. La commutation magnétique obtenue par injection d'un courant pulsé, avec une aimantation initiale de la couche ferromagnétique orientée selon Z et pour lequel le pulse de courant est appliqué en présence d'un champ magnétique de 0.04T orienté selon la direction X du courant.

La figure 13 illustre un système d'émission selon l'invention de type spin-LED selon une deuxième variante (vue de profil).

La figure 14 illustre le système d'émission selon l'invention de type spin-laser selon une deuxième variante (vue de profil).

La figure 15 illustre un mode de réalisation d'un spin laser selon l'invention dans lequel le deuxième miroir du spin-laser est disposé sur la barre de Hall et est un miroir de Bragg comme le premier miroir.

La figure 16 illustre les premier (A) et deuxième (B) modes de réalisation appliqués à la deuxième variante du système selon l'invention.

La figure 17 illustre la variation de la résistance de Hall anormale en fonction de l'intensité impulsionnelle injectée dans la barre de Hall.

## DESCRIPTION DETAILLEE DE L'INVENTION

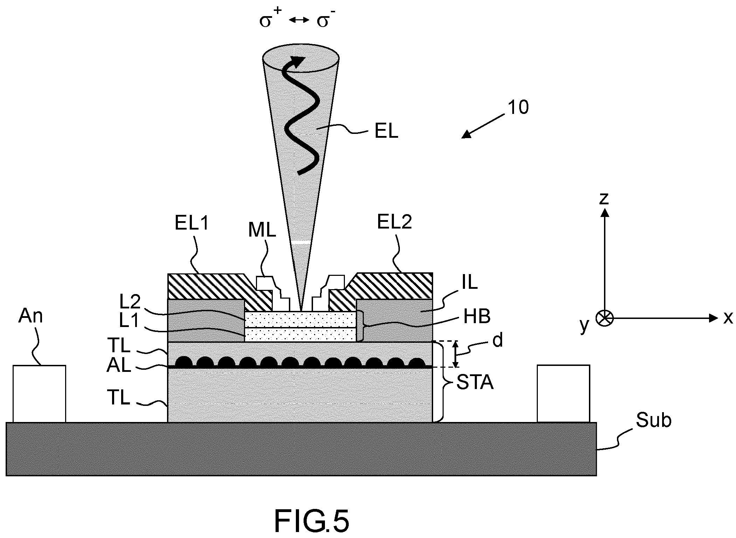

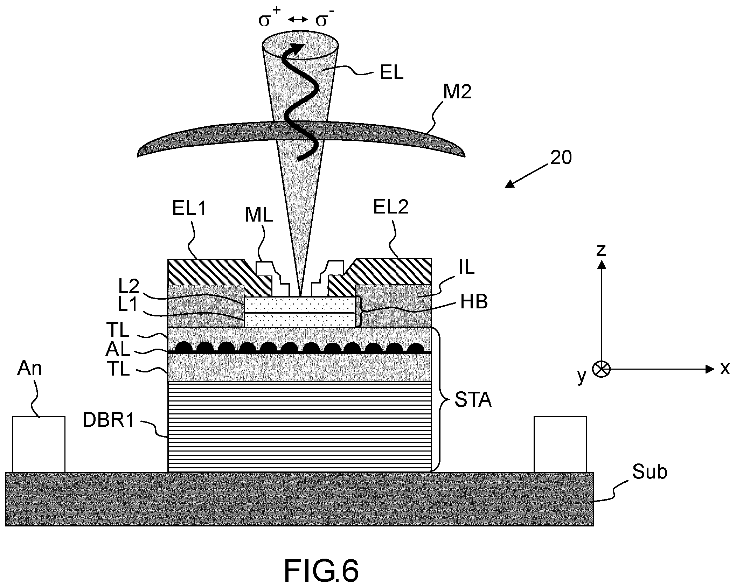

Le système d'émission selon l'invention de type spin-LED 10 et le système d'émission selon l'invention de type spin-laser 20 sont illustrés respectivement sur les figures 5 et 6 (vues de profil). Le système comprend un empilement STA déposé sur un substrat Sub selon un axe Z perpendiculaire au plan XY du substrat, l'empilement comprenant une couche active AL et des couches de transport. Selon un mode de réalisation la couche active comprend des boîtes quantiques (quantum dots QD) ou des puits quantiques (Quantum wells QW) en mono ou multicouches. Le substrat, les couches de transport et toute autre couche additionnelle permettant d'obtenir l'émission lumineuse de la LED ou du laser sont classiques et ne seront pas décrits. Par exemple le substrat et les diverses couches pour l'émission lumineuse sont à base de GaAs ou de GaN ou de GaSb ou d'un autre composé III-V, ou d'une combinaison de ceux-ci.

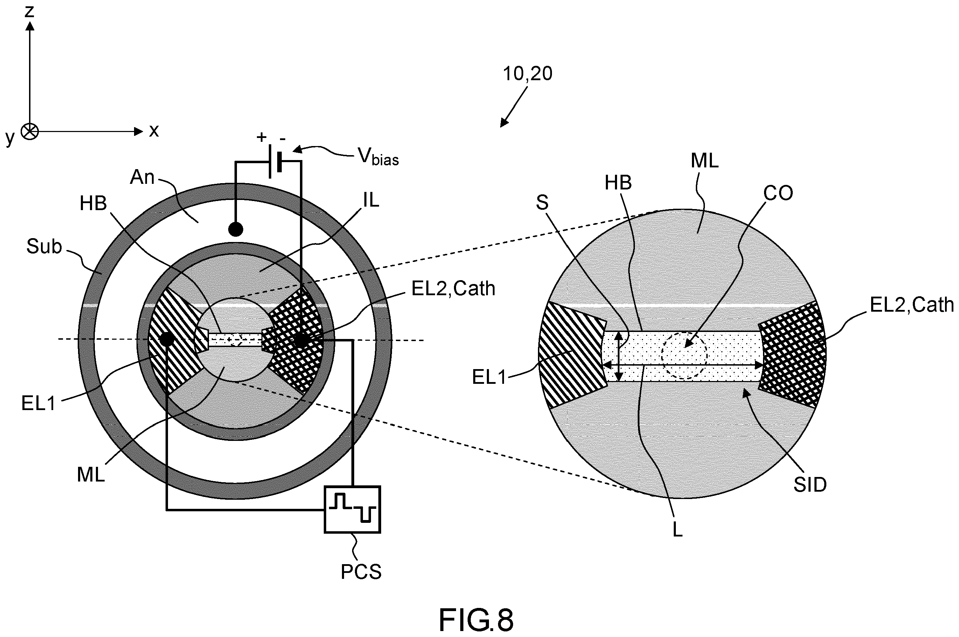

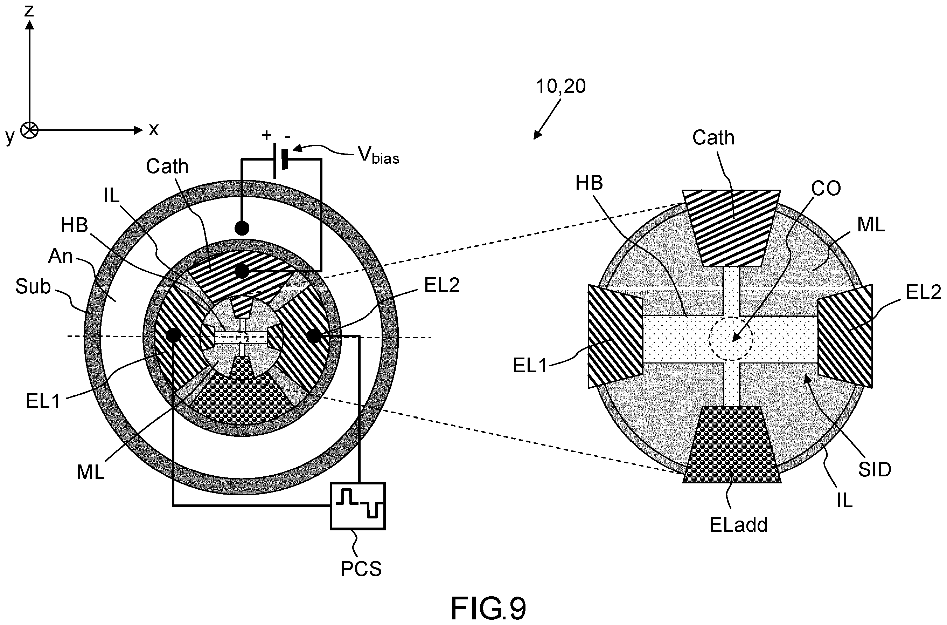

Le système d'émission 10 ou 20 comprend également une électrode dénommée anode An et une électrode dénommée cathode Cath configurées pour générer des porteurs de charge qui traversent l'empilement jusqu'à la couche active. Les porteurs de charges injectés par l'anode sont typiquement les trous et les porteurs de charges injectés par la cathode sont des électrons dénommés électrons d'émission. Typiquement les électrons et les trous se recombinent de manière radiative pour générer une émission lumineuse EL, de manière classique. La cathode Cath peut être disposée de deux manières différentes et n'est pas illustrée sur les figures 5 et 6, mais sur les figures 8 et 9 décrites plus loin. La cathode et l'anode sont par exemple, et de manière classique, en un matériau typiquement constitué d'une bicouche titane et d'or (Ti(10nm)/Au(50nm)) ou d'un alliage de AuGeNi pour éviter un contact Schottky avec les semi-conducteurs ,de type n.

Le système d'émission selon l'invention comprend également un dispositif dit injecteur de spin SID original déposé sur l'empilement STA. L'injecteur SID comprend un ensemble d'au moins une première couche L1 très fine en matériau ferromagnétique Mfer et d'au moins une deuxième couche L2 très fine en matériau métallique Mmet.

Préférentiellement le métal Mmet est un métal lourd, tel que le tantale (Ta), le tungstène (W), le bismuth (Bi), le platine (Pt), le terbium (Tb) ou tout alliage de ces matériaux. On entend par métal lourd un métal présentant un numéro atomique élevé bénéficiant d'un fort couplage spin-orbite (en particulier au niveau de Fermi).

Typiquement le matériau ferromagnétique Mfer est choisi parmi: CoFeB, Co, Fe, CoFe, FePt, CoPt, FeTb ou tout alliage de même type (métaux de transition et possiblement terres rares).

Selon un mode de réalisation l'ensemble comprend une seule couche de chaque matériau et selon un autre mode de réalisation l'ensemble comprend plusieurs couches de l'un ou de l'autre des matériaux, voir des couches d'autres éléments, dans un agencement de type multicouche.

Dans une variante l'ensemble comprend également une couche d'un matériau à forte conduction électronique (Cu, Au,..), ceci afin d'amplifier les effets de SOT extrinsèque ou intrinsèque proche des interfaces (voir plus loin), comme dans le cas du Pt.

Chaque couche est ultra fine, typiquement d'épaisseur inférieure à 10 nm, préférentiellement inférieure à 5 nm, pouvant atteindre 1 nm dans la limite inférieure (CoFeB). L'ensemble L1/L2 présente une structure de barre, dénommée barre de Hall HB, selon un axe X et présente une première extrémité et une deuxième extrémité. La barre HB présente une épaisseur e faible, typiquement inférieure à 10-20 nm, une largeur S selon Y et une longueur L selon X. On entend par forme de barre un élément de forme allongée, avec une longueur L supérieure ou égale à 2.5 fois la largeur S, préférentiellement supérieure ou égale à 4 ou 5 fois S. A titre d'exemple non limitatif la longueur L est de l'ordre de 100-150 $\mu$m, la largeur S de l'ordre de 20-50 $\mu$m.

L'injecteur SID comprend également une première électrode EL1 et une deuxième électrode EL2, dites de spin, en contact électrique avec respectivement la première et la deuxième extrémité de la barre de Hall HB, et configurées pour générer, dans la barre de Hall, un courant I impulsionnel selon l'axe X dans un premier sens s1 ou un deuxième sens s2 opposé au premier sens. Préférentiellement pour simplifier la fabrication des électrodes de contact, toutes les électrodes (incluant donc l'anode et la cathode) sont dans un même matériau, par exemple un bicouche de titane et d'or (Ti/Au).

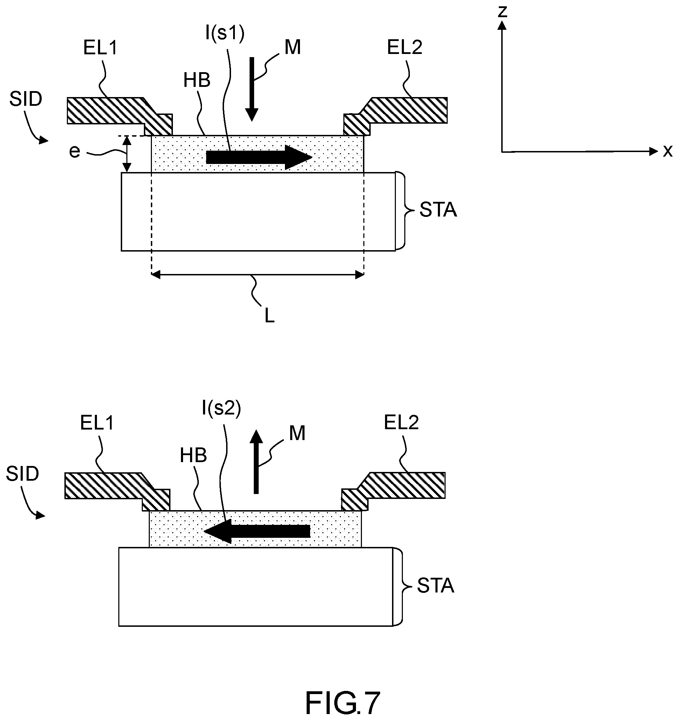

La figure 7 illustre le principe de fonctionnement de l'injecteur, qui sera décrit plus précisément plus loin. L'injecteur est basé sur l'utilisation du couplage spin-orbite (Spin Orbit coupling en anglais) donnant lieu à un effet de couple de spin-orbite (désigné par l'acronyme SOT pour spin-orbit torque en anglais) réalisé par l'effet Hall de Spin (Spin Hall Effect en anglais désigné par l'acronyme SHE). Le SOT-SHE est par exemple décrit dans la publication « Spin Torque Switching with the Giant Spin Hall effect of Tantalum » de Liu et al. (Science VOL 336, 555, 2012). La barre de Hall est réalisée typiquement par lithographie.

La couche ferromagnétique L1, et donc l'injecteur SID, est configurée pour présenter une composante $M_z$ d'aimantation M selon l'axe Z (anisotropie magnétique perpendiculaire ou Perpendicular Magnetic Anisotropy PMA en anglais). Un champ statique $H_{ext}$ de faible intensité, aligné selon l'axe X, impose une composante $M_x$ d'aimantation non nulle suivant l'axe X. Le SHE permet aux électrons polarisés en spin d'interagir avec le ferromagnétique en exerçant un couple $\square_{SOT}$ aligné sur l'axe Y, dont le signe dépend du sens du courant. Le couple $\square_{SOT}$ se manifeste comme résultant d'un champ effectif $H_{SOT}$ selon l'axe X. Lorsque ce champ effectif $H_{SOT}$ et le champ $H_{ext}$ s'ajoutent dans le même sens, et pour des densités de courants injectés supérieures à une certaine densité de courant critique, cela provoque un basculement ou commutation de l'aimantation. Si leurs sens sont opposés, il n'y a pas de basculement; l'état est stable et reste stable après suppression du courant d'injection. L'injecteur de spin selon l'invention utilisant le SHE est configuré pour qu'une inversion du sens du courant I réalise un renversement du sens de la composante $M_z$ de l'aimantation M. A titre d'exemple un courant I injecté (véhiculé par les électrons de spin) selon un premier sens s1 induit une aimantation selon Z orientée selon un sens vers le bas et un courant I injecté selon un deuxième sens s2 induit une aimantation selon Z orientée selon un sens vers le haut, tel qu'illustré sur la figure 7. Le courant injecté est impulsionnel, chaque impulsion de courant pouvant être très courte, avec une durée caractéristique d'impulsion pouvant être réduite jusqu'à quelques ps par exemple. La commutation de l'aimantation, réalisée avec un courant impulsionnel très court, peut être très rapide permettant ainsi un fonctionnement à grande vitesse, c'est-à-dire une commutation de la polarisation à grande vitesse.

Le système d'émission est configuré en outre de sorte que la cathode Cath est en contact électrique avec la barre de Hall HB de l'injecteur de spin SID. Les électrons d'émission traversent au moins partiellement l'injecteur et subissent l'influence de l'aimantation de l'injecteur, cette influence se traduisant par une polarisation de spin des électrons d'émission, et ainsi une émission de polarisation majoritairement CG ou CD en fonction du sens de M. Ainsi une commutation de l'aimantation de l'injecteur de spin induit une modification de l'état de polarisation circulaire de la lumière EL émise par le système d'émission. Une fois la commutation effectuée et l'état de polarisation souhaité obtenu par application du courant impulsionnel, l'application du courant impulsionnel de commutation n'est plus nécessaire pour continuer d'émettre de la lumière dans la polarisation circulaire obtenue. Le courant impulsionnel ne sert qu'à réaliser la commutation de l'aimantation magnétique et donc à changer la polarisation de la lumière émise.

Les figures 5 et 6 illustrent une première variante selon laquelle un matériau isolant IL est déposé sur l'empilement STA et autour de l'injecteur, de manière à pouvoir déposer les électrodes de spin EL1 et EL2.

Lorsque le système d'émission est un spin-laser 20 l'empilement STA comprend en outre un premier miroir DBR1 disposé sur le substrat Sub et un deuxième miroir M2 agencé de sorte que l'injecteur soit disposé à l'intérieur d'une cavité optique formée par le premier et le deuxième miroir. Sur le mode de réalisation illustré sur la figure 6 le miroir M2 est externe, c'est-à-dire à l'extérieur de l'ensemble empilement +injecteur. Le premier miroir DBR1 est typiquement un miroir de Bragg, par exemple constitué d'une alternance de couche de GaAs et de AlGaAs. Le spin-laser est de type VECSEL.

Préférentiellement, pour éviter les problèmes dus à l'insertion des couches métalliques (L1+L2) dans la cavité optique, le système d'émission spin laser 20 est configuré de sorte que l'injecteur de spin est placé dans un nœud du champ électromagnétique stationnaire à la surface de la structure ½-VCSEL. Cela permet de minimiser l'absorption par la couche ferromagnétique de l'injecteur de spin.

Afin de résoudre le problème d'inadéquation de résistivité entre les métaux et les semi-conducteurs, selon un mode de réalisation préféré le système d'émission lumineuse comprend en outre une couche mince isolante TIL disposée entre l'injecteur de spin et l'empilement (non représentée sur les figures), typiquement en oxyde de magnésium MgO (également dénommé barrière tunnel). Préférentiellement cette couche s'étend sur toute la surface de l'empilement. Dans ce cas la structure de l'ensemble STA/HB est semiconducteur/isolant/ferromagnétique/métal lourd. Un exemple de structure est donné à titre illustratif: Semiconducteur/MgO/CoFeB/Ta.

Selon un mode de réalisation le système d'émission lumineuse selon l'invention comprend en outre une couche de masquage isolante ML disposée sur l'injecteur de spin, et présentant une ouverture circulaire CO de surface inscrite dans la barre de Hall et délimitant la zone d'émission lumineuse. La couche de masquage présente une épaisseur déterminée de sorte qu'elle soit opaque vis-à-vis de la ou des longueurs d'onde de la lumière émise. La couche de masquage est par exemple en $SiO_2$. Dans ce cas la lumière émise à partir de l'ouverture circulaire est compatible avec le mode d'émission $TEM_{00}$.

Du fait du positionnement de l'injecteur de spin juste au-dessus de l'empilement STA il est possible de rendre la distance entre l'injecteur SID et la couche active très faible. Préférentiellement l'empilement est configuré de sorte que la distance (d) entre l'injecteur de spin et la couche active demeure inférieure à 100 nm.

Selon un premier mode de réalisation illustré figure 8 (vue de dessus) la cathode Cath et l'une des électrodes de spin (la deuxième électrode de spin EL2 sur la figure 8) forment une seule et même électrode. Le courant impulsionnel, dont le sens est modifié à grande vitesse, est envoyé dans le canal de l'injecteur (barre HB, électrodes de spin EL1 et EL2) via le générateur de courant pulsé PCS. Simultanément l'injecteur est polarisé négativement (tension entre l'électrode An et l'électrode Cath=EL2) à l'aide d'une tension de biais « verticale » Vbias (2-3V) pour avoir une émission laser continue. Donc la polarisation entre $\sigma^+$ et $\sigma$- sera modulée selon le sens de l'aimantation M de l'injecteur. Cette configuration de la barre de Hall est simple. Elle ne permet pas de mesurer la résistance de Hall anormale $R_{AHE}$.

Selon un deuxième mode de réalisation illustré figure 9 (vue de dessus) le système d'émission lumineuse 10 ou 20 selon l'invention présente une cathode Cath en contact avec la barre de Hall HB via une paroi latérale de HB. Elle est disposée, comme EL1 et EL2, sur le matériau isolant IL. Typiquement si on considère la cathode Cath (point milieu de la HB) comme référence de tension, les potentiels à appliquer aux contacts EL1 et EL2 sont opposés, et s'inversent à chaque commutation. Le potentiel d'anode reste à Vbias.

Le courant I dont le sens est modulé/renversé à grande vitesse est injecté dans le canal via EL1 et EL2 et une tension de biais Vbias est simultanément appliquée entre l'anode An et la cathode Cath.

Selon un sous mode de réalisation également illustré figure 9 le système d'émission comprend en outre une électrode additionnelle ELadd en contact électrique avec la barre de Hall HB via une paroi latérale du côté opposé à la cathode Cath. Préférentiellement l'ensemble EL1, EL2, Cath et ELadd forme une structure symétrique de type croix de Hall. Cette électrode additionnelle permet, lors de la caractérisation du système, de mesurer la résistance de Hall anormale $R_{AHE}$, égale au ratio entre la tension mesurée entre Cath et ELadd et la densité du courant impulsionnel injecté I entre EL1 et EL2. Cette mesure permet de sonder la direction d'aimantation M.

Les avantages du système d'émission selon l'invention sont multiples et dûs à la structure originale de l'injecteur de spin SID.

Premièrement la vitesse de commutation, basée sur la modulation de polarisation circulaire est en principe limitée par le temps de commutation de l'aimantation de l'injecteur de spin, qui approche les 200 GHz, ce qui rend possible une vitesse de fonctionnement environ 6 fois plus rapide que celle de la modulation d'intensité conventionnelle (35 GHz pour l'état de l'art dans les VCSELs). Cette rapidité est obtenue car il n'est plus nécessaire de commuter un champ magnétique extérieur pour commuter M.

Deuxièmement, la consommation d'énergie est très réduite dans le spin-laser. D'une part parce que le courant de seuil est réduit, car il traduit une population de porteurs hors-équilibre d'une seule catégorie de spin, qui est donc augmentée en pompage (optique ou électrique) circulaire, et d'autre part car les débits binaires les plus élevés peuvent être atteints juste au-dessus du seuil.

Troisièmement, le degré de polarisation circulaire de la lumière cohérente peut être modulé en continu en fonction de la direction d'aimantation de l'injecteur de spin. En d'autres termes le système d'émission selon l'invention peut émettre en continu, la commutation de M étant commandée indépendamment de la génération des électrons d'émission. Ainsi, grâce à l'injecteur de spin selon l'invention, la polarisation agit comme une dimension de codage supplémentaire conduisant à l'augmentation de la bande passante de la transmission optique.

En outre l'injecteur de spin est très fin (par exemple d'épaisseur inférieure à 5 nm lorsque chacune des deux couches L1 L2 est de l'ordre de 2nm), ce qui permet de l'intégrer dans la cavité optique pour les lasers de spin, en raison de sa très faible perte d'absorption optique. Dans ce cas, la distance entre l'injecteur de spin et la région active est très faible (<100 nm), ce qui permet d'injecter efficacement des électrons polarisés en spin dans la région active, ce qui conduit à une bonne polarisation circulaire Pc de l'émission de lumière.

L'effet physique à l'origine de la commutation de l'aimantation M d'un bicouche via le courant le traversant est détaillé ci-dessous, et décrit dans la publication «Current -induced switching of perpendicularly magnetized magnetic layers using spin torque from the Spin Hall effect » de Liu et al, (Physical Review Letters, 109, 096602 (2012)).

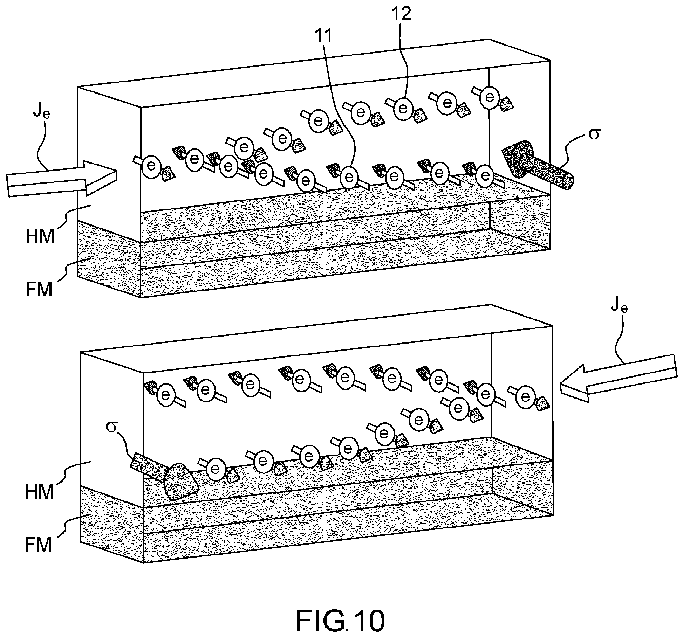

En utilisant l'effet Hall de spin SHE via le couplage spin-orbite SOT, on peut commuter électriquement l'aimantation M d'un bicouche métal ferromagnétique FM / métal lourd HM. Lorsqu'un courant de charge Je est injecté dans la couche HM, en raison de l'effet Hall de spin via la diffusion dépendante du spin, les électrons de spins opposés 11, 12 auront tendance à s'accumuler sur les surfaces supérieure et inférieure de la couche HM, tel qu'illustré figure 10. Lors du changement de direction de Je, un spin d'électron de direction différente s'accumule à l'interface HM/FM, et il en résulte une polarisation de spin opposée $\vec{\sigma}$.

A l'interface HM/FM la polarisation de spin générée par l'accumulation de spin hors d'équilibre $\vec{\sigma}$ produit un couple spin-orbite $\vec{\tau}_{SOT}$ sur l'aimantation $\vec{M}$ de la couche adjacente FM selon la formule :

$$\vec{\tau}_{SOT} = \vec{M} \times \vec{\sigma} \times \vec{M}.$$

Le couple de spin-orbite $\vec{\tau}_{SOT}$ génère un champ effectif $\vec{H}_{SOT}$ qui permet de commuter l'aimantation de la couche ferromagnétique FM. La commutation peut s'effectuer à très grande vitesse (voir la publication Jhuria et al « Spin-orbit torque switching of a ferromagnet with picosecond electrical pulses » Nature Electronics, 3, 680 (2020)).

L'idée originale de l'invention est d'utiliser cet effet de commutation pour réaliser un nouveau type d'injecteur de spin d'un spin-LED ou spin-laser.

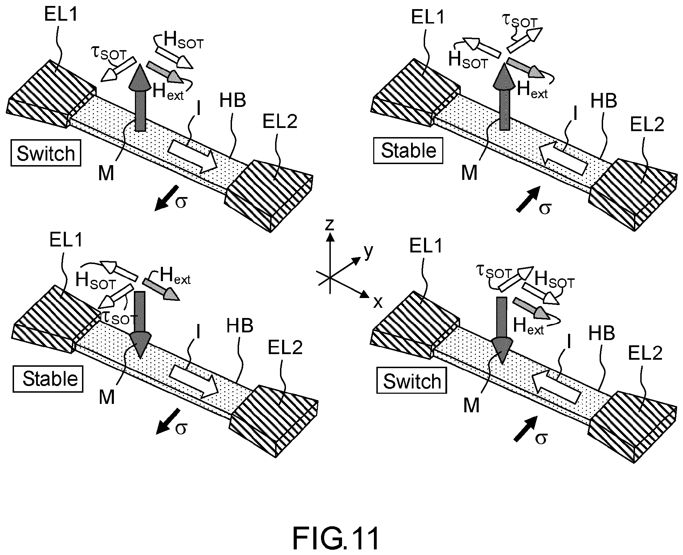

La figure 11 montre schématiquement la commutation d'aimantation utilisée dans la structure barre de Hall HB de l'injecteur selon l'invention pour les quatre situations avec des directions différentes de $\vec{M}$ et de I, pour un injecteur selon le premier mode de réalisation (EL2=Cath).

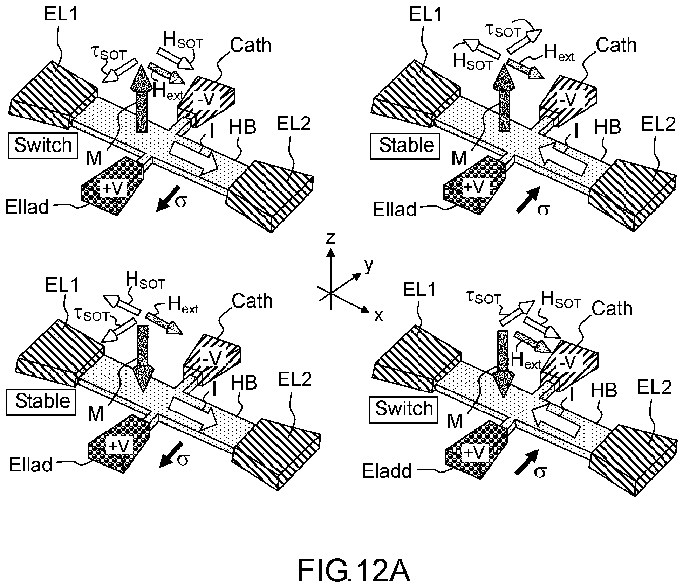

La figure 12A montre schématiquement la commutation d'aimantation utilisée dans la structure barre de Hall HB de l'injecteur selon l'invention pour les quatre situations avec des directions différentes de $\vec{M}$ et de I, pour un injecteur selon le deuxième mode de réalisation (EL2 distincte de Cath). Pour évaluer la résistance de Hall anormale $R_{AHE}$, il faut mesurer la différence de potentiel apparaissant entre les 2 électrodes Cath et ELadd pendant l'application du courant de contrôle I.

Les électrons d'émission sont injectés dans un milieu aimanté qu'ils traversent, leur direction de spin s'aligne selon la direction d'aimantation du matériau aimanté, puis ils descendent dans la structure semi-conductrice. En d'autres termes le courant dans le HB latéral, qui peut commuter l'aimantation, contrôle le spin des électrons d'émission.

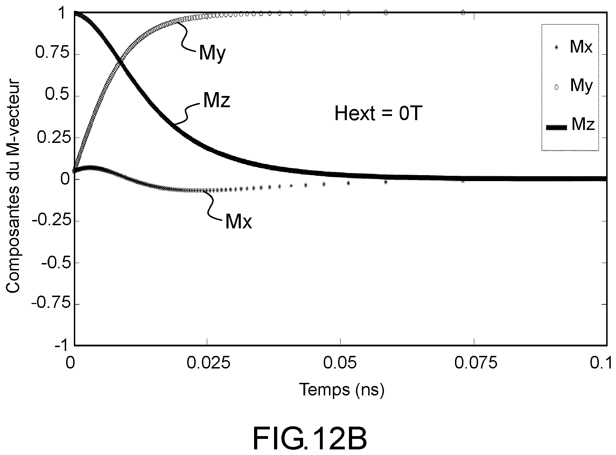

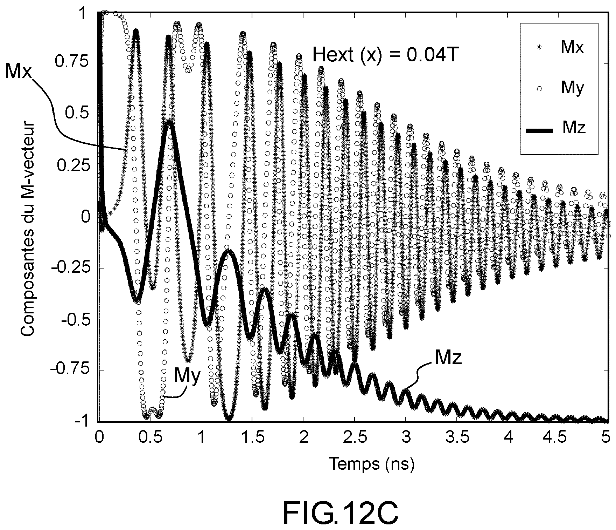

Les électrons provenant du générateur Vbias qui vont traverser la zone semiconducteur seront tous passés par la couche ferromagnétique dont l'aimantation va contribuer à polariser le spin. Une fois l'aimantation de la couche ferromagnétique orientée, le flux électronique (provenant du générateur de Vbias) contenant autant de spins « up » et « down » ne changera pas l'aimantation du matériau ferromagnétique, mais ce flux va se polariser en spin. Pour obtenir une commutation d'aimantation perpendiculaire déterministe, selon un mode de réalisation on applique un petit champ magnétique externe $\vec{H}_{ext}$ le

long de la direction X du canal de l'injecteur. Il y a deux raisons à cela. La première raison est que le champ magnétique appliqué $\vec{H}_{ext}$, même faible, peut aider le champ effectif $\vec{H}_{SOT}$ à commuter $\vec{M}$ lorsqu'ils sont dans la même direction, comme le montre les figures 11 et 12 pour le cas «switch». La deuxième raison est que ce même champ $\vec{H}_{ext}$ annulera le $\vec{H}_{SOT}$ pour stabiliser une orientation d'aimantation particulière lorsqu'ils sont dans des directions opposées. Lors de l'injection d'une direction de courant opposée dans le canal, la direction de l'aimantation de l'injecteur peut alors être contrôlée. La valeur du champ $\vec{H}_{ext}$ nécessaire est faible, typiquement inférieure ou égale à 100 mT (voir publication Liang et al « Electrical switching of perpendicular magnetization in a single ferromagnetic layer » Phys. Rev. B 101, 220402 2020). Typiquement le champ magnétique $\vec{H}_{ext}$ représente en valeur une fraction de l'anisotropie magnétique perpendiculaire qui permet de maintenir l'aimantation hors du plan.

Ainsi pour ce mode de réalisation le système d'émission comprend un dispositif de génération du champ magnétique externe $\vec{H}_{ext}$ selon l'axe X. Ce champ $\vec{H}_{ext}$ n'a pas à être commuté pour réaliser la commutation de $\vec{M}$. Pour sonder la direction d'aimantation, on peut mesurer la résistance de Hall anormale $R_{AHE}$ via l'électrode additionnelle ELadd précitée.

Les figures 12B et 12C illustrent un exemple de simulation de commutation magnétique obtenue par injection d'un courant pulsé de 150 ps et d'amplitude Js = $4{\times}10^8$ A/cm$^2$, et avec une aimantation initiale de la couche ferromagnétique orientée selon Z (Mz = +1).

La structure de la couche ferromagnétique est ici considérée comme uniforme et consiste donc en un monodomaine magnétique (l'anisotropie magnétique perpendiculaire est ici de 0.5 T et le coefficient d'amortissement $\alpha$= 0,01). Les deux couches utilisées pour la simulation sont une couche de CoFeB de 1 nm et une couche de Pt de 3 nm.

La figure 12B illustre le cas pour lequel le pulse de courant est appliqué sans champ magnétique externe (Hext=0). La figure 12C illustre le cas pour lequel le pulse de courant est appliqué en présence d'un champ magnétique de 0.04T orienté selon la direction X du courant. Pour chaque cas la dépendance temporelle des 3 composantes de l'aimantation, respectivement Mx, My et Mz est décrite.

Dans le cas Hext=0, le couple magnétique agissant sur l'aimantation initialement orientée selon l'axe z normal au plan des multicouches permet la mise en mouvement de l'aimantation donnant lieu aux deux autres composantes, My et Mx. La stabilisation de l'aimantation aux temps longs est obtenue assez rapidement et l'équilibre est obtenu pour une aimantation dans le plan orientée selon l'axe Y transverse à la direction X du pulse courant injecté. Le couple magnétique n'est pas suffisant dans ce cas pour renverser entièrement l'aimantation selon la direction -Z comme souhaité et l'état final sera non déterministe caractérisé par un état d'aimantation +/- Z selon la normale.

Dans le cas Hext(x)=0.04T, l'application d'un petit champ magnétique de 0.04 T selon l'axe X brise cette symétrie particulière de l'effet Hall de spin et, dans les mêmes conditions expérimentales, le pulse de courant permet alors de renverser totalement l'aimantation selon la direction -Z comme souhaité, malgré les précessions multiples faisant apparaître de fortes oscillations magnétiques donnant lieu à l'apparition des composantes Mx et My. Dans cet exemple le temps de stabilisation est de l'ordre de 1 ns, et le pulse de courant de 150 ps est suffisant pour renverser totalement l'aimantation dans la direction souhaitée. L'optimisation de la durée de l'impulsion à des temps plus courts permet une commutation magnétique plus rapide pour atteindre les performances souhaitées en terme de fréquence de transfert de l'information.

Selon d'autres modes de réalisation on évite l'utilisation d'un champ magnétique externe en utilisant différentes stratégies.

Selon un premier mode de réalisation on réalise une asymétrie structurelle latérale de la barre HB, qui donne lieu à un nouveau couple spin-orbite lorsque le courant est injecté dans la barre. La direction du champ effectif induit par le courant correspondant à ce couple spin-orbite est hors du plan, ce qui facilite la commutation d'aimants perpendiculaires. (voir la publication Yu et al., «Switching of perpendicular magnetization by spin-orbit torques in the absence of external magnetic fields », Nature nanotechnology, 9, 548 (2014)).

Selon un deuxième mode de réalisation la couche ferromagnétique L1 est un film d'alliage ferromagnétique de composition non uniforme (voir la publication Liang et al « Electrical switching of perpendicular magnetization in a single ferromagnetic layer » Phys Rev B 101, 220402 (R), 2020 précitée), qui génère un champ électrique selon la normale au plan de la couche et en conséquence un champ magnétique dans le plan (qui est celui recherché) pour aider à la commutation, par le biais du couplage spin-orbite précité.

Selon un troisième mode de réalisation on réalise une croissance de la (ou des) mulicouches sur un substrat caractérisé par une orientation spécifique (111) et donnant lieu à une structure monocristalline bien définie dans son ensemble. L'anisotropie magnétique associée comprendra un terme définissant un champ magnétique effectif dans le plan, celui recherché pour la commutation. L'apparition d'un tel champ magnétique dans le plan des couches est la conséquence d'une brisure de symétrie d'inversion dans ce même plan, générant des couples de spin orbite additionnels dont on peut, en l'occurrence, tirer bénéfice. (voir la publication Liu et al « Symmetry dependent field-free switching of perpendicular magnetization », Nature technology, 16, 277-282, 2021).

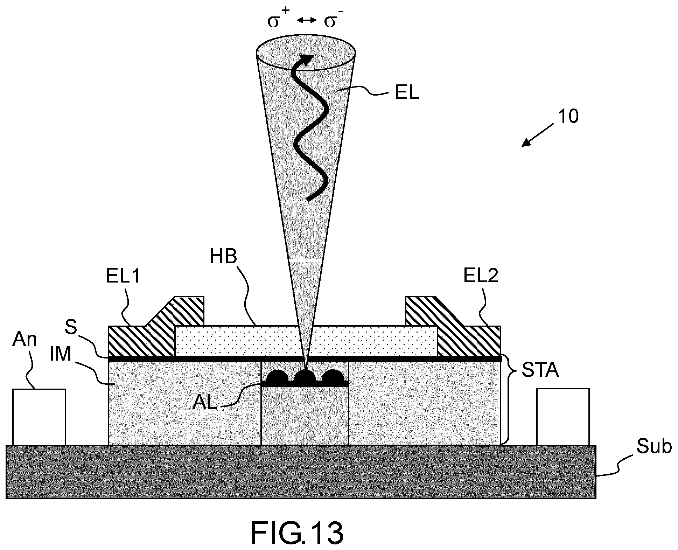

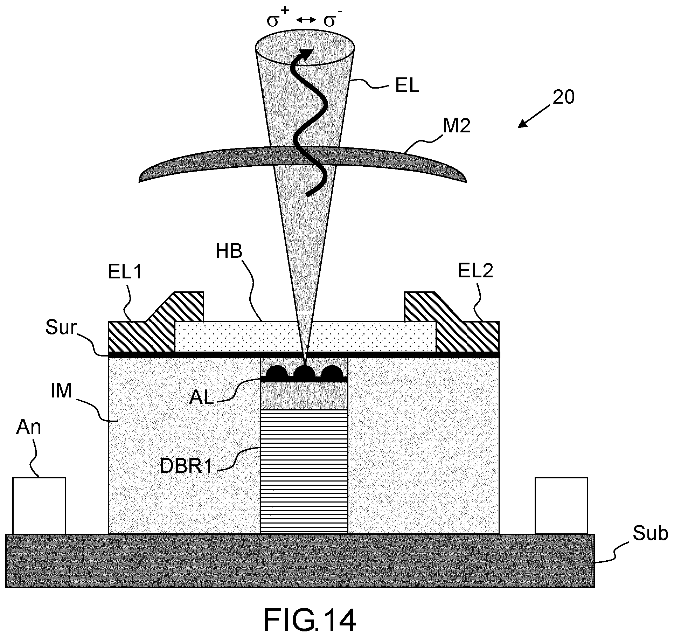

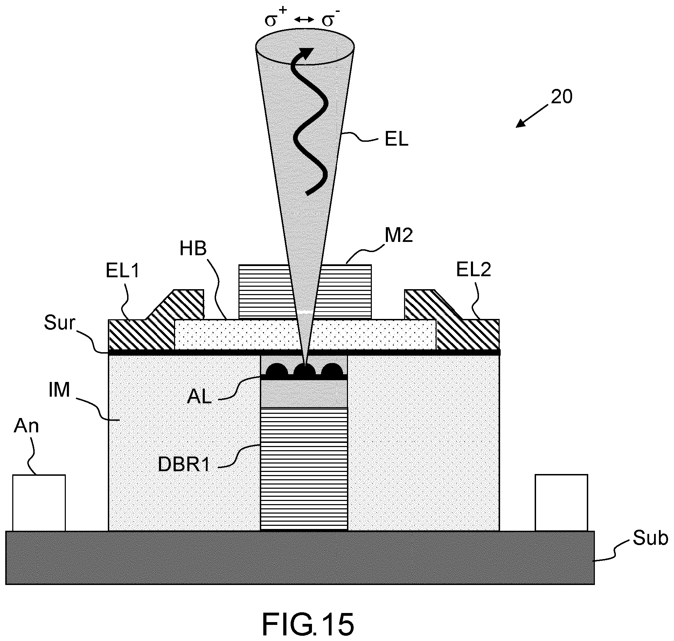

Pour garantir que le courant injecté selon la verticale (direction Z) pour l'émission laser soit injecté de manière homogène dans la zone active AL du laser de spin, on s'arrange pour que la surface de la barre de l'injecteur de spin HB recouvre toute la surface de la couche active et plus. Pour cela selon une deuxième variante l'empilement STA est entouré par un matériau isolant IM (par exemple une résine photosensible BCB) et forme avec l'empilement une surface supérieure plane Sur sur laquelle sont disposés l'injecteur de spin et la cathode, comme illustré figure 13 pour la spin-LED et figure 14 et 15 pour le spin-laser.

Selon un mode de réalisation le deuxième miroir M2 du spin-laser est disposé sur la barre HB tel qu'illustré figure 14. Le deuxième miroir M2 peut également être remplacé par un miroir de Bragg, tel qu'illustré figure 15. Un avantage est de rendre le spin-laser plus miniaturisé. Cela permet également de réduire considérablement le coût du système et d'améliorer la fiabilité du composant.

Dans ces exemples l'empilement STA est à titre illustratif de forme cylindrique (par exemple de diamètre 50 $\mu$m) et le matériau isolant disposé autour de l'empilement a également une forme cylindrique. L'anode est disposée sur le substrat Sub et présente une forme d'anneau entourant le cylindre. La largeur S de la barre HB est choisie sensiblement égale à 50 $\mu$m, soit au diamètre de l'empilement.

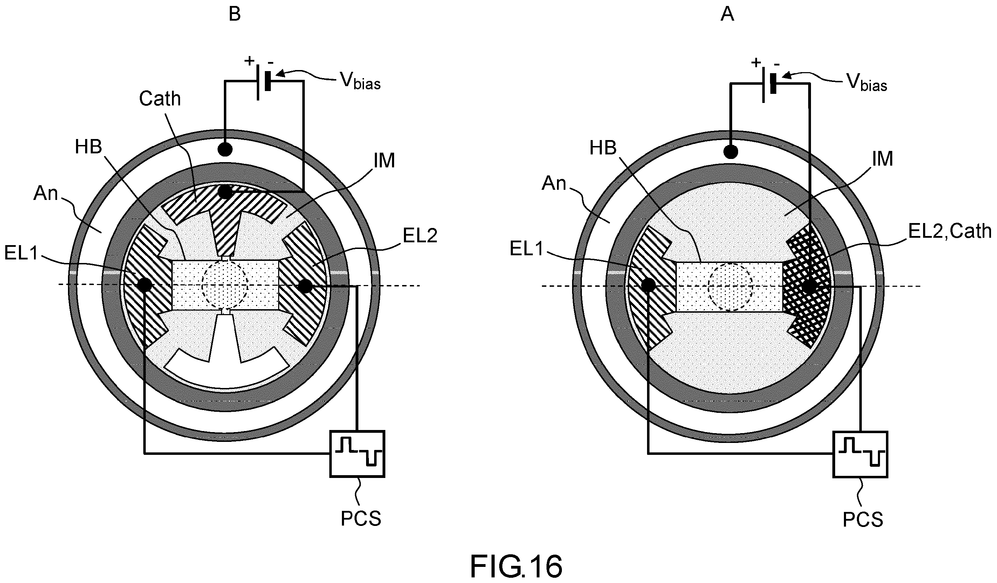

Cette deuxième variante également illustrée figure 16 est compatible du premier mode de réalisation (A) avec une cathode coïncidant avec la deuxième électrode de spin et du deuxième mode de réalisation (B) avec une cathode latérale.

Pour fabriquer le système d'émission on fabrique d'abord par lithographie le micro-pilier semi-conducteur de diamètre 50$\mu$m. Ensuite, la zone environnante est remplie d'un matériau isolant (par exemple une résine photosensible BCB) de manière à obtenir une surface Sur plane. Les couches de l'injecteur de spin sont déposées sur la surface Sur et une étape de lithographie forme la structure de barre. Étant donné que la surface de la barre HB peut couvrir toute la surface du micro-pilier semi-conducteur, le courant injecté pour l'émission laser circule de manière homogène dans la zone active du semi-conducteur. Dans cette conception, la couche de couverture opaque isolante ML n'est plus nécessaire et l'ensemble de l'empilement émet la lumière. Cependant avec cette structure il peut être problématique d'obtenir une interface injecteur/semi-conducteur propre, ce qui pourrait influencer l'efficacité de l'injection de spin. Étant donné que la procédure de lithographie apporte de la colle résiduelle ou des défauts à la surface du semi-conducteur, il est nécessaire d'effectuer un nettoyage chimique approprié sur la surface du semi-conducteur avant de déposer les couches de l'injecteur de spin.

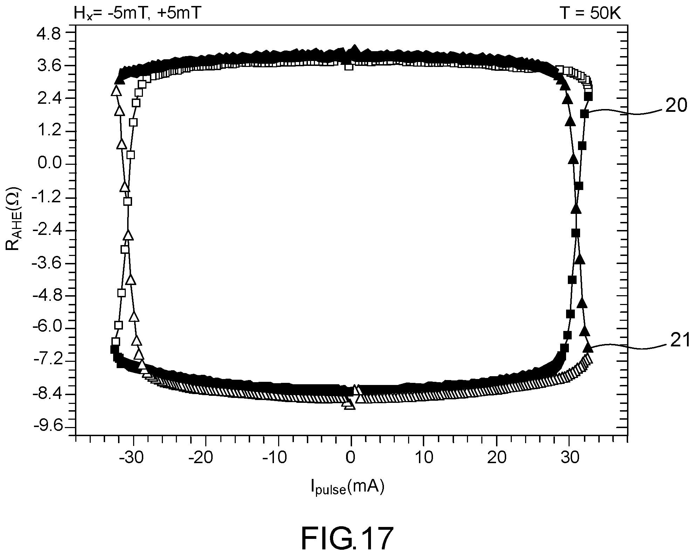

La figure 17 illustre la commutation de l'aimantation effectuée avec un injecteur de spin SID selon l'invention présentant un premier exemple de structure multicouche CoFeB (1.1 nm) / Ta (2 nm) / CoFeB (0.8 nm) déposée sur un substrat GaAs non dopé, avec une couche TIL en MgO (2.5 nm) entre l'injecteur et le substrat.

La structure multicouche est traitée par lithographie UV pour fabriquer la structure de barre de l'injecteur de spin sur le dessus de la mésa. La commutation d'aimantation par SHE dans un injecteur de spin en forme de barre de Hall selon l'invention est mise en évidence en mesurant la résistance Hall anormale ($R_{AHE}$, rapport entre la tension longitudinale et le courant transversal sur la structure de la barre Hall) en fonction de l'intensité du courant impulsionnel $i_{pulse}$ injecté dans la barre HB. Pour l'expérience un petit champ extérieur Hext de + 5 mT (courbe 20) ou - 5 mT (courbe 21) est appliqué. On constate sur la figure 17 que l'aimantation est commutée avec une intensité de courant 30 mA à 50 K (durée de l'impulsion 100$\mu$s).

**Revendications**

1. Système d'émission lumineuse (10, 20) de type spin-LED ou spin-laser comprenant :

   - un empilement (STA) déposé sur un substrat (Sub) selon un axe Z perpendiculaire au plan XY du substrat et comprenant une couche active (AL) et des couches de transport,
   - une électrode dénommée anode (An) et une électrode dénommée cathode (Cath) configurées pour générer des porteurs de charge qui traversent l'empilement jusqu'à la couche active,
   - un dispositif dit injecteur de spin (SID) déposé sur ledit empilement et comprenant :

      • un ensemble d'au moins une première couche (L1) en matériau ferromagnétique et d'au moins une deuxième couche (L2) en matériau métallique, ledit ensemble présentant une structure de barre dénommée barre de Hall (HB) selon un axe X et présentant une première extrémité et une deuxième extrémité,
      • une première électrode (EL1) et une deuxième électrode (EL2), dites de spin, en contact électrique avec respectivement la première et la deuxième extrémité de la barre de Hall, et configurées pour générer, dans la barre de Hall, un courant I impulsionnel selon l'axe X dans un premier sens ou un deuxième sens opposé au premier sens,

   - le système d'émission étant configuré de sorte que la cathode est en contact électrique avec la barre de Hall de l'injecteur de spin,
   - ledit injecteur de spin étant configuré pour présenter une aimantation (M) selon l'axe Z et pour qu'une inversion du sens du courant I réalise une inversion du sens de l'aimantation (M), une commutation de l'aimantation de l'injecteur de spin induisant une modification d'un état de polarisation circulaire de la lumière (EL) émise par le système d'émission.

2. Système d'émission (20) selon la revendication précédente de type spin-laser dans lequel l'empilement comprend en outre un premier miroir (DBR1) disposé sur le substrat et un deuxième miroir (M2) agencé de sorte que l'injecteur soit disposé à l'intérieur d'une cavité optique formée par le premier et le deuxième miroir.

3. Système d'émission (20) de type spin-laser selon la revendication précédente dans lequel le deuxième miroir est disposé sur l'injecteur de spin et est un miroir de Bragg.

4. Système d'émission lumineuse selon l'une des revendications précédentes dans lequel une longueur (L) de la barre de Hall est supérieure ou égale à 2.5 fois une largeur (S) de ladite barre de Hall.

5. Système d'émission lumineuse selon l'une des revendications précédentes comprenant en outre une couche mince isolante (TIL) disposée entre l'injecteur de spin et l'empilement.

6. Système d'émission lumineuse selon l'une des revendications précédentes comprenant en outre une couche de masquage (ML) opaque à la lumière émise, disposée sur l'injecteur de spin, et présentant une ouverture circulaire (CO) de surface inscrite dans la barre de Hall et délimitant la zone d'émission lumineuse.

7. Système d'émission lumineuse selon l'une des revendications précédentes dans lequel la première couche, la deuxième couche et, le cas échéant, la couche mince isolante, présentent chacune une épaisseur inférieure à 5 nm.

8. Système d'émission lumineuse selon l'une des revendications précédentes dans lequel l'empilement est configuré de sorte qu'une distance (d) entre l'injecteur de spin et la couche active est inférieure à 100 nm.

9. Système d'émission lumineuse selon l'une des revendications précédentes dans lequel la cathode et l'une des électrodes de spin forment une seule et même électrode.

10. Système d'émission lumineuse selon l'une des revendications 1 à 8 dans lequel la cathode est en contact avec la barre de Hall via une paroi latérale de la barre de Hall.

11. Système d'émission lumineuse selon la revendication précédente comprenant en outre une électrode additionnelle (ELadd) en contact électrique avec la barre de Hall via une paroi latérale du côté opposé à la cathode.

12. Système d'émission lumineuse selon l'une des revendications précédentes comprenant en outre un dispositif de génération d'un champ magnétique dit externe selon l'axe X.

13. Système d'émission lumineuse selon l'une des revendications précédentes dans lequel l'empilement (STA) est entouré par un matériau isolant (IM), le matériau isolant formant avec l'empilement une surface supérieure plane (Sur) sur laquelle sont disposés l'injecteur de spin et la cathode.

**Patentansprüche**

1. Lichtemissionssystem (10, 20) vom Spin-LED- oder Spin-Laser-Typ, umfassend:

   - einen Stapel (STA), der auf einem Substrat (Sub) entlang einer zur XY-Ebene des Substrats senkrechten Z-Achse eingerichtet ist und eine aktive Schicht (AL) und Transportschichten umfasst,
   - eine als Anode (An) bezeichnete Elektrode und eine als Kathode (Cath) bezeichnete Elektrode, die konfiguriert sind, um Ladungsträger zu erzeugen, die den Stapel bis zur aktiven Schicht durchqueren,
   - eine Spin-Injektionsvorrichtung (SID), die auf dem Stapel eingerichtet ist und umfasst:

      - eine Anordnung aus mindestens einer ersten Schicht (L1) aus ferromagnetischem Material und mindestens einer zweiten Schicht (L2) aus metallischem Material, wobei die Anordnung eine als Hall-Stab (HB) bezeichnete Stabstruktur entlang einer X-Achse aufweist und ein erstes Ende sowie ein zweites Ende aufweist,
      - eine erste Elektrode (EL1) und eine zweite Elektrode (EL2), sogenannte Spin-Elektroden, die mit dem ersten bzw. dem zweiten Ende des Hall-Stabs in elektrischem Kontakt stehen und konfiguriert sind, um im Hall-Stab einen Impulsstrom I entlang der X-Achse in einer ersten Richtung oder in einer zweiten, der ersten Richtung entgegengesetzten Richtung zu erzeugen,

   - wobei das Emissionssystem so konfiguriert ist, dass die Kathode in elektrischem Kontakt mit dem Hall-Stab des Spin-Injektors steht,
- wobei der Spin-Injektor so konfiguriert ist, dass er eine Magnetisierung (M) entlang der Z-Achse aufweist und dass eine Umkehrung der Stromrichtung I eine Umkehrung der Magnetisierungsrichtung (M) herbeiführt, wobei eine Umschaltung der Magnetisierung des Spin-Injektors eine Modifikation eines zirkularen Polarisationszustands des vom Emissionssystem emittierten Lichts (EL) induziert.

2. Emissionssystem (20) nach dem vorstehenden Anspruch vom Spin-Laser-Typ, wobei der Stapel weiter einen ersten Spiegel (DBR1), der auf dem Substrat angeordnet ist, und einen zweiten Spiegel (M2) umfasst, der so angeordnet ist, dass der Injektor im Inneren einer optischen Kavität angeordnet ist, die durch den ersten und den zweiten Spiegel gebildet wird.

3. Emissionssystem (20) vom Spin-Laser-Typ nach dem vorstehenden Anspruch, wobei der zweite Spiegel auf dem Spin-Injektor angeordnet ist, und ein Bragg-Spiegel ist.

4. Lichtemissionssystem nach einem der vorstehenden Ansprüche, wobei eine Länge (L) des Hall-Stabs größer oder gleich dem 2,5-fachen einer Breite (S) des Hall-Stabs ist.

5. Lichtemissionssystem nach einem der vorstehenden Ansprüche, weiter umfassend eine dünne Isolierschicht (TIL), die zwischen dem Spin-Injektor und dem Stapel angeordnet ist.

6. Lichtemissionssystem nach einem der vorstehenden Ansprüche, weiter umfassend eine für das emittierte Licht undurchlässige Maskierungsschicht (ML), die auf dem Spin-Injektor angeordnet ist und eine kreisförmige Öffnung (CO) aufweist, deren Oberfläche in den Hall-Stab eingeschrieben ist und die den Lichtemissionsbereich begrenzt.

7. Lichtemissionssystem nach einem der vorstehenden Ansprüche, wobei die erste Schicht, die zweite Schicht und gegebenenfalls die dünne Isolierschicht jeweils eine Dicke von weniger als 5 nm aufweisen.

8. Lichtemissionssystem nach einem der vorstehenden Ansprüche, wobei der Stapel so konfiguriert ist, dass ein Abstand (d) zwischen dem Spin-Injektor und der aktiven Schicht weniger als 100 nm beträgt.

9. Lichtemissionssystem nach einem der vorstehenden Ansprüche, wobei die Kathode und eine der Spin-Elektroden ein und dieselbe Elektrode bilden.

10. Lichtemissionssystem nach Anspruch 1 bis 8, wobei die Kathode über eine Seitenwand des Hall-Stabs mit dem Hall-Stab in Kontakt steht.

11. Lichtemissionssystem nach dem vorstehenden Anspruch, weiter umfassend eine zusätzliche Elektrode (ELadd), die über eine Seitenwand auf der der Kathode gegenüberliegenden Seite in elektrischem Kontakt mit dem Hall-Stab steht.

12. Lichtemissionssystem nach einem der vorstehenden Ansprüche, weiter umfassend eine Vorrichtung zur Erzeugung eines sogenannten externen Magnetfelds entlang der X-Achse.

13. Lichtemissionssystem nach einem der vorstehenden Ansprüche, wobei der Stapel (STA) von einem Isoliermaterial (IM) umgeben ist, wobei das Isoliermaterial zusammen mit dem Stapel eine ebene obere Oberfläche (Sur) bildet, auf welcher der Spin-Injektor und die Kathode angeordnet sind.

**Claims**

1. Light emission system (10, 20) of the spin-LED or spin-laser type, comprising:

   - a stack (STA) deposited on a substrate (Sub) along an axis Z perpendicular to the plane XY of the substrate and comprising an active layer (AL) and transport layers,
   - an electrode referred to as anode (An) and an electrode referred to as cathode (Cath), configured to generate charge carriers which pass through the stack up to the active layer,
   - a device called spin injector (SID) deposited on said stack and comprising:

     - an assembly of at least one first layer (L1) made of ferromagnetic material and of at least one second layer (L2) made of metal material, said assembly having a bar structure referred to as Hall bar (HB) along an axis X and having a first end and a second end,
     - a first electrode (EL1) and a second electrode (EL2), referred to as spin electrodes, in electrical contact with respectively the first and the second end of the Hall bar, and configured to generate, in the Hall bar, a pulsed current I along the axis X in a first direction or a second direction opposite to the first direction,

   - the emission system being configured, so that the cathode is in electrical contact with the Hall bar of the spin injector,

- said spin injector being configured to have magnetisation (M) along the axis Z and so that a reversal of the direction of the current I causes a reversal of the direction of the magnetisation (M), a change in the magnetisation of the spin injector inducing a change in the state of circular polarisation of the light (EL) emitted by the emission system.

2. Emission system (20) according to the preceding claim, of the spin-laser type, wherein the stack further comprises a first mirror (DBR1) disposed on the substrate and a second mirror (M2) arranged so that the injector is disposed inside an optical cavity formed by the first and the second mirror.

3. Emission system (20) of the spin-laser type according to the preceding claim, wherein the second mirror is disposed on the spin injector and is a Bragg mirror.

4. Light emission system according to any one of the preceding claims, wherein a length (L) of the Hall bar is greater than or equal to 2.5 times a width (S) of said Hall bar.

5. Light emission system according to any one of the preceding claims, further comprising a thin insulating layer (TIL) disposed between the spin injector and the stack.

6. Light emission system according to any one of the preceding claims, further comprising a masking layer (ML) opaque to the light emitted, disposed on the spin injector, and having a circular opening (CO) of surface inscribed in the Hall bar and delimiting the light emission zone.

7. Light emission system according to any one of the preceding claims, wherein the first layer, the second layer and, where necessary, the thin insulating layer, each have a thickness less than 5 nm.

8. Light emission system according to any one of the preceding claims, wherein the stack is configured so that a distance (d) between the spin injector and the active layer is less than 100 nm.

9. Light emission system according to any one of the preceding claims, wherein the cathode and one of the spin electrodes form one single and same electrode.

10. Light emission system according to any one of claims 1 to 8, wherein the cathode is in contact with the Hall bar via a side wall of the Hall bar.

11. Light emission system according to the preceding claim, further comprising an additional electrode (ELadd) in electrical contact with the Hall bar via a side wall on the side opposite the cathode.

12. Light emission system according to any one of the preceding claims, further comprising a device for generating a so-called external magnetic field along the axis X.

13. Light emission system according to any one of the preceding claims, wherein the stack (STA) is surrounded by an insulating material (IM), the insulating material forming, with the stack, a flat upper surface (Sur) on which the spin injector and the cathode are disposed.

FIG.1

FIG.2

EP 4 566 134 B1

FIG.3

EP 4 566 134 B1

FIG.4

FIG.5

FIG.6

FIG.7

FIG.8

FIG.9

EP 4 566 134 B1

EP 4 566 134 B1

FIG.10

23

FIG.11

FIG.12A

FIG.12B

FIG.12C

EP 4 566 134 B1

FIG.13

EP 4 566 134 B1

FIG.14

FIG.15

FIG.16

FIG.17

## RÉFÉRENCES CITÉES DANS LA DESCRIPTION

**Littérature non-brevet citée dans la description**

- Injection and detection of a spin-polarized current in a light-emitting diode. *Nature*, 1999, vol. 402
- **NILS C. GERHARDT et al.** Spin Controlled Vertical Cavity Surface Emiitting Lasers. *Advances in Optical technology*, vol. 2012
- **CADIZ et al.** Electrical Initialization of Electron and Nuclear Spins in a Single Quantum dot at zero magnetic field. *Nano Letters*, 2018, vol. 18, 2381-2386
- **LIANG et al.** *Physical Review B*, 2014, vol. 90, 085310
- **YOKOTA et al.** Spin polarization modulation for high-speed vertical-cavity surface-emitting lasers. *Applied Physics Letters*, 2018, vol. 113, 171102
- **LIU et al.** Spin Torque Switching with the Giant Spin Hall effect of Tantalum. *Science*, 2012, vol. 336, 555

- **LIU et al.** Current -induced switching of perpendicularly magnetized magnetic layers using spin torque from the Spin Hall effect. *Physical Review Letters*, 2012, vol. 109, 096602
- **JHURIA et al.** Spin-orbit torque switching of a ferromagnet with picosecond electrical pulses. *Nature Electronics*, 2020, vol. 3, 680
- **LIANG et al.** Electrical switching of perpendicular magnetization in a single ferromagnetic layer. *Phys. Rev. B*, 2020, vol. 101, 220402
- **YU et al.** Switching of perpendicular magnetization by spin-orbit torques in the absence of external magnetic fields. *Nature nanotechnology*, 2014, vol. 9, 548
- **LIANG et al.** Electrical switching of perpendicular magnetization in a single ferromagnetic layer. *Phys Rev B*, 2020, vol. 101, 220402
- **LIU et al.** Symmetry dependent field-free switching of perpendicular magnetization. *Nature technology*, 2021, vol. 16, 277-282